# EUROPEAN PATENT SPECIFICATION

(11) **EP 2 601 689 B1**
(45) Date of publication and mention of the grant of the patent: **29.06.2016**
(21) Application number: 10755239.0
(22) Date of filing: 06.08.2010
(51) Int. Cl.: H01L 31/054, H02S 40/42, H01L 31/052

(54) **MODULE FOR HIGH CONCENTRATING PHOTOVOLTAICS**
MODUL FÜR HOCHKONZENTRIERENDE FOTOVOLTAIK
MODULE POUR PHOTOVOLTAÏQUE À CONCENTRATION ÉLEVÉE

(43) Date of publication of application: 12.06.2013
(73) Proprietor: Pirelli & C. S.p.A., 20126 Milano (IT)
(72) Inventor: BUSQUETS, Marc, 08242 Manresa, Barcelona (ES); RICCI, Fabrizio, I-20126 Milano (IT); BOFFA, Vincenzo, I-20126 Milano (IT); FORGAS, Albert, 08860, Castelldefels, Barcelona (ES); MARCIPAR, Javier, E-08034 Barcelona (ES); SOLINA, Martin, 08860, Castelldefels Barcelona (ES); CALOPA, Pere, E-08184 Barcelona (ES); LARA, José Martìn, E-08184 Barcelona (ES)
(74) Representative: Tansini, Elio Fabrizio
(86) International application number: PCT/IB2010/053569
(87) International publication number: WO 2012/017274

(56) References cited:
- WO-A1-2010/025550
- WO-A2-2009/038307
- DE-A1- 19 919 023
- DE-U1-202009 006 442
- JP-A- 2000 091 612
- US-A1- 2009 107 541
- US-A1- 2009 260 674
- US-B1- 6 483 093

## Description

### Field of the invention

The present invention relates to a module for high concentrating photovoltaics, in particular for high concentrating refractive photovoltaics.

### Background of the invention

The term concentrating photovoltaics (CPV) refers to concentration of sunlight onto photovoltaic materials for the purpose of electrical power production. The solar concentrators realizing this are typically mounted on a solar tracker which is a mechanical supporting structure capable of keeping the focal point upon the photovoltaic materials as the sun moves across the sky. Compared to conventional non-concentrating photovoltaics, CPV is advantageous because it makes use of less quantity of semiconductor photovoltaic material.

The term high concentrating photovoltaics (HCPV) refers to an optical system having a geometric concentrating factor equal to or greater than about 100 and, typically, less than or equal to about 1000. The geometric concentrating factor is defined as the ratio between the optical active area of the optical system, which collects the solar radiation, and the area of the spot that the optical system concentrates on the photovoltaic material.

The term concentrating refractive photovoltaics refers to concentration of sunlight using a refractive optical system, typically based on Fresnel lenses, as opposed to reflective optical systems that use one or more mirrors. Typically, the necessary length along the focusing direction of the solar concentrators with refractive optical systems is longer than that of reflective optical systems.

Exemplarily, US Patent Application US2010018570 relates to a photovoltaic concentrator module.

US 6,483,093 B1 relates to a solar generator system including a solar cell for photo-electrically converting sunlight, a multi-focus lens for condensing and converging the sunlight to the solar cell, and a secondary light-condenser.

### Summary of the invention

The Applicant has realized that known modules for high concentrating photovoltaics suffer from several disadvantages. In particular, the known heat dissipating systems are not considered satisfactory in terms of simplicity of production and/or assembling, especially in view of a mass-production, and/or material consumption. Heat dissipation is a key factor in concentrating photovoltaics since the efficiency of the solar cell lowers with the increase of its temperature.

In particular, in the known heat dissipating systems each dissipating element is singularly dedicated to a single photovoltaic receiver (e.g. the latter is singly mounted onto the dissipating element). A dissipating element dedicated to each single photovoltaic receiver must be designed to reach very high dissipating efficiency. However, the Applicant observes that this may result in a complex structure of the dissipating element (e.g. having a high number of wings, flaps, pins, foldings, etc) and/or large bulkiness (e.g. large thickness, heavy weight, etc) of the dissipating element. Furthermore, dedicating a dissipating element to each single photovoltaic receiver requires that a gap is left between adjacent dissipating elements, in order to allow the mounting of the dissipating elements onto the concentration module and/or to allow thermal expansion of the dissipating elements. In turn, this limits the available space for each single dissipating element. A dissipating element having limited space may result in insufficient dissipation efficiency or high complexity and/or bulkiness of its structure. Moreover, dedicating to each photovoltaic receiver a respective dissipating element requires a high number of attachment points between the dissipating elements and the housing of the concentration module, which in turn increases the complexity of the assembling, e.g. in terms of work load and finally assembling costs.

The Applicant has found that by mounting dissipating linear elements onto an outer side of the bottom wall of a concentration module, and by mounting rows of photovoltaic receivers onto such dissipating linear elements, it is possible to reach high heat dissipation efficiency and keep, at the same time, the geometrical complexity and/or the bulkiness of the dissipating linear elements limited. It has also been found that the intermediate portions of the dissipating linear element comprised between two adjacent photovoltaic receivers effectively contribute to dissipate the heat from the receivers, so that the provision of a complex configuration of dissipating surfaces and/or high bulkiness is actually not needed for the dissipating linear elements. Furthermore, the dissipating linear elements can greatly contribute to the mechanical stabilization of the concentrating module housing.

The present invention relates to a module for high concentrating photovoltaics including a housing having a bottom wall, one or more side walls connected to the bottom wall, and at least an aperture located opposite the bottom wall. A plurality of photovoltaic units is housed in the housing. Each of said photovoltaic units comprises a concentrating optical system having geometric concentrating factor greater than or equal to about 100 and a photovoltaic receiver having a photovoltaic cell. The plurality of photovoltaic receivers are arranged at the bottom wall and along a plurality of parallel rows. The module further comprises a heat dissipating system comprising a number of dissipating linear elements for dissipating heat from the photovoltaic receivers, the dissipating linear elements being mounted onto an outer side of the bottom wall. In an aspect, the number of dissipating linear elements is equal to the number of said rows. All the photovoltaic receivers arranged along each of said rows can be mounted onto a corresponding one of said dissipating linear elements so as to realize a thermal bridge between each photovoltaic receiver and the corresponding dissipating linear element.

In an aspect, the housing is substantially made of steel, preferably containing no more than about 10% (more preferably no more than about 5%) of chrome and/or no more than about 0,2% of carbon. Preferably the housing is zinc-coated, more preferably on both sides, for example by zinc-plating (e.g. hot-galvanizing or electrogalvanizing) and/or varnishing (which may include prior cataphoresis of the steel housing). Preferably, the two sides of the housing are treated differently, for example only zinc-plating the inner side and, preferably in addition to zinc-plating, varnishing the outer side. In an aspect, the dissipating linear elements are made from a material including aluminum, preferably containing at least 75% (more preferably at least 90%) of aluminum. Preferably, the material includes at least 2% of magnesium (preferably less than 5%) and/or other elements such as iron, silicon, manganese, etc, in small percentage (e.g. less than 1%). According to the Applicant, the above choice of materials, having comparable (or at least not too different) thermal expansion coefficients (such as about 2,4x10⁻⁵ °C⁻¹ for aluminum-based compound and about 1,2x10⁻⁵ °C⁻¹ for steel), allows to dedicate a single dissipating linear element to a number of photovoltaic receivers arranged along a row having a desired length without incurring in, or limiting, the occurrence of stresses onto the various parts of the module (e.g. the housing and/or the dissipating element) due to different thermal expansion. These stresses may generate geometrical deformations of the various parts of the module, which is particularly detrimental in the light of the tight tolerance for the HCPV module in the positioning of the optical focus onto the photovoltaic cell.

It is noted that some known materials for the housing and the dissipating elements (such as for example some kind of plastics for the housing and aluminum-based alloy for the dissipating elements) have their thermal expansion coefficients very different, which causes the need of a single dissipating element for each photovoltaic receiver in order to avoid the occurrence of undesired thermal expansion stresses.

Typically, the housing has a prevalent or main direction of development (which will be called 'longitudinal direction') and an orthogonal direction (which will be called 'transversal direction'), belonging to planes parallel to the bottom wall. A depth direction is orthogonal to both the longitudinal and transverse directions. Typically, the housing has four side walls. The two mutually opposite side walls developing parallel to the longitudinal direction will be called longitudinal side walls and the two mutually opposite side walls developing parallel to the transversal direction will be called transversal side walls. The longitudinal side walls have a greater length than the length of the transversal side walls. Typically, the bottom wall and the side walls of the housing define an inner space extending from the bottom wall up to, and including, the above mentioned aperture.

In an aspect, the housing is a one-piece housing. Preferably, the housing is formed by a single sheet of steel (preferably by deep drawing the single sheet) having preferred thickness greater than or equal to 0.65mm, more preferably greater than or equal to 0.75mm and/or less than or equal to 1.1mm, more preferably less than or equal to 1.0 mm.

In an aspect, the housing depth is greater than or equal to 15 cm, preferably 18 cm. In an aspect, the housing depth is less than or equal to 25 cm, preferably 22 cm.

In an aspect the maximum thickness of the housing (considering also the possible zinc layers formed during galvanization, having typically a thickness of about 0.1 mm per side and/or formed during varnishing, having typically a thickness of about 0.25 mm per side) is greater than or equal to 0.7mm, more preferably greater than or equal to 0.8mm. Preferably the maximum thickness of the housing is less than or equal to 1.5mm, more preferably less than or equal to 1.2mm. The Applicant believes that the above choice of ranges of thickness, in case the housing is made of steel, gives an optimal trade-off between feasibility and simplicity of the deep drawing stamping process, stiffness of the housing and weight.

Preferably, the housing integrally includes a first plurality of parallel and continuous ribs running along the bottom wall and the two transversal side walls and a second plurality of parallel and continuous ribs running along the bottom wall and the two longitudinal side walls, the ribs of the second plurality crossing on the bottom wall perpendicularly to each rib of the first plurality. Preferably, each rib is formed as a protrusion with respect to the respective wall, the protrusion having height comprised between about 0.5% and 5% of the housing depth (e.g. comprised between about 1mm and 10mm when the housing depth is within the above ranges). Preferably the protrusion develops towards the inner space of the housing. Preferably, the width of the ribs is comprised between about 2% and 20% of the housing dimension along the transversal direction (e.g comprised between about 10mm and 100mm, preferably between about 20mm and 80 mm). Preferably, the ribs of the first plurality extend along the bottom wall parallel to the longitudinal direction of the housing. Preferably, the ribs of the first plurality are two. Preferably, the ribs of the second plurality extend along the bottom wall perpendicular to the longitudinal direction of the housing. Preferably, the ribs of the second plurality are between three and seven, for example five. According to the Applicant, one or more of the above solutions for the ribs helps keeping parallelism and planarity of desired areas of the housing where critical elements are placed, such as for example the free edge of the side walls and the inner face of the bottom wall where, respectively, primary optical lens parquets and photovoltaic receivers are placed and attached.

Preferably, the edges formed between the bottom wall and the side walls, and the vertices of the housing, are rounded. Preferably, a portion on the free edge of each side wall is outwardly bent with respect to the inner space of the housing, for a length comprised between about 5mm and 40 mm. Preferably the bent portion defines a prop surface (e.g. having width between about 5mm and 20mm) laying substantially perpendicularly to the respective side wall. According to the Applicant, the rounding of the edges and/or the vertices, and/or the above bent portion improves the stiffness of the housing.

In an aspect, the photovoltaic receivers are regularly arranged according to a matrix scheme, i.e. they are aligned not only along the above plurality of parallel rows, but also along a plurality of further rows oblique (preferably orthogonal) to the aforementioned parallel rows.

The bottom wall has a plurality of through holes corresponding in number and position to respectively the number and position of the photovoltaic receivers. Preferably, the photovoltaic receivers arranged along each of said row are directly mounted onto the corresponding one of said dissipating linear elements. In this way advantageously, because of the presence of the holes, the above mentioned thermal bridge is realized without the interposition of the bottom wall between the dissipating element and the receivers, thus increasing the thermal dissipation. Preferably, the holes have a rectangular shape, with side's length comprised between about 15mm and 40mm.

In an aspect, the dissipating linear elements are aligned along the transversal direction of the housing. In this way advantageously the air convection along the dissipating linear element may be enhanced, since the module in operation (i.e. mounted on the solar tracker) is typically placed with its longitudinal direction lying on a horizontal plane, and typically rotates around the longitudinal direction, so that the alignment direction of the dissipating linear elements has a vertical component. The heated air near the dissipating element may thus flow along the alignment direction of the dissipating linear elements in proximity of the dissipating element itself.

Preferably, the module comprises a number of transversal rows of photovoltaic receivers greater than or equal to two, preferably greater than or equal to six. Preferably, the module comprises less than or equal to twenty, more preferably less than or equal to sixteen, transversal rows of photovoltaic receivers.

In an aspect, the number of photovoltaic receivers arranged along each of said rows and mounted onto a corresponding one of said dissipating linear elements is greater than or equal to two, preferably greater than or equal to three. Preferably, the number of photovoltaic receivers arranged along each of said rows and mounted onto a corresponding one of said dissipating linear elements is less than or equal to ten, preferably less than or equal to eight.

In an aspect, the dissipating linear element is a plate-like element having a main longitudinal (with respect to the dissipating element itself) extension and a central longitudinal portion lying substantially on a lying plane and having two mutually opposite edges developing longitudinally to the dissipating element. From the above opposite edges of the central longitudinal portion, a pair of opposite flaps extend in the same half-space with respect to the lying plane and obliquely to the lying plane, preferably substantially orthogonally to the lying plane. Preferably the flaps are mirror flaps with respect to a symmetry plane perpendicular to the lying plane and centrally intersecting the central longitudinal portion parallel to the main longitudinal extension of the dissipating linear element. The Applicant believes that this shape gives the best trade-off between simplicity of fabrication and efficiency of dissipation.

Preferably, cut-outs are realized on the free edge of each flap. Such cut-outs can extend up to about half of the height of the flap. The cut-outs may be positioned midway the positions of two adjacent photovoltaic receivers. Preferably the cut-outs are approximately circular in shape. According to simulations conducted by the Applicant for comparing the thermal performances of the dissipating linear elements with and without the cut-outs, it has been found that the heat profile is almost unchanged. Therefore the advantage of reducing material and weight can be gained without any sensible drawback.

In an aspect, each dissipating linear element integrally comprises a number, equal to the number of photovoltaic receivers mounted onto the dissipating linear element, of mounting portions protruding from the central longitudinal portion of the dissipating linear element. Each mounting portion can have a flat top surface and a shape countershaped to the shape of the above mentioned hole of the bottom wall (preferably a rectangular shape) of the housing, and it is inserted in the latter.

Each photovoltaic receiver is (preferably directly) mounted on a respective mounting portion of the dissipating linear element. Preferably, the height of the mounting portions with respect to the face of the remaining central longitudinal portion from which they protrude is greater than the thickness of the bottom wall. In this way, advantageously, the photovoltaic receiver remains protected from water in case of moisture condensation inside the housing.

In an aspect, the thickness of the dissipating linear element is greater than or equal to 1.5mm, more preferably greater than or equal to 1.8mm. Preferably the thickness of the dissipating linear element is less than or equal to 2.5mm, more preferably less than or equal to 2.2mm.

In an aspect, the dissipating linear element is realized by a stamping process comprising deep drawing a planar sheet of suitable shape.

In an aspect, the dissipating linear elements are mounted onto the bottom wall by riveting. Preferably, the number of rivets for each dissipating linear element is less than four times the number of the photovoltaic receivers mounted onto the respective dissipating linear element, more preferably less than the latter number. Preferably, the number of rivets for each dissipating linear element is equal to three. Preferably the rivets are inserted along the direction from bottom wall to dissipating element, and they do not pierce the dissipating element. In this way they are advantageously air tight and water proof. Alternatively, the rivets may pierce both the dissipating element and the housing, and a sealing material is used to realize an air and water-proof seal.

In an aspect, the concentrating optical systems have geometric concentrating factor greater than or equal to about 200, preferably 300, more preferably 400 and/or less than or equal to 1000, preferably 800, more preferably 700. Preferably, each concentrating optical system comprises a primary optical element (POE) for collecting the direct solar radiation from the outside of the housing and a secondary optical element (SOE) for focusing the radiation collected from the POE onto the photovoltaic cell. Preferably the concentrating optical systems are refractive optical systems. Preferably the optical system is a Fresnel-Köhler concentrator type system (exemplarily having a focal length of about 20 cm) wherein the POE comprises an axially symmetric Fresnel lens which is divided into 4 off-axis sectors and the SOE comprises a refractive secondary lens, also divided in four sectors. Each Fresnel sector works in pairs with a counterpart sector on the SOE lens to perform the integration of the light and achieve outstanding irradiance uniformity on the solar cell.

In an aspect, the module comprises at least one (preferably a plurality, e.g. three) parquet comprising an array (preferably 4x4 each) of POE lenses manufactured together as one piece. Typically the parquet(s) is/are positioned on the aperture of the housing so as to cover it. Preferably at least two opposite edges (preferably all four edges of the single parquet or, in case of a plurality of parquets, three edges of the two end parquets and/or two opposite edges of any possible middle parquet) of the parquet(s) lean against the above mentioned prop surface of the bent portion of the side walls.

In an aspect, the module comprises at least one beam spanning transversally the aperture of the housing and having its opposite longitudinal (with respect to the beam itself) ends fixed respectively to the free edge of the longitudinal side walls. Preferably, the module comprises two or more (the number being preferably equal to the number of the above parquets diminished by a unit) beams as above, positioned so as to divide the aperture in equal parts. The beam(s) may contribute to add stiffness to the longitudinal side walls, which could be otherwise subject to flexion and/or torsion since they cannot be longitudinally stiffened during stamping (for example it is not possible to form by stamping ribs extending longitudinally or transversally along a side wall, i.e. perpendicularly to the stamping direction). Preferably at least one edge of each one of the above plurality of parquets (e.g. two opposite edges of any possible middle parquet) lean against one of the above beam(s).

In an aspect the module includes one pillar for each parquet having a base fixed to the bottom wall and a tip opposite to the base fixed to the geometrical center of the respective parquet so as to keep spatially fixed the center of the parquet both in the depth direction of the housing and in any orthogonal direction thereof. In this way it is possible to reduce the concentration of the parquet expansion on one side only of the parquet and to make the deformations of the parquet substantially symmetrical with respect to the centre point.

In an aspect the photovoltaic cell is a multi-junction cell preferably based on the III-V group element compound like InGaP, InGaAs and Ge. Preferably the cell side is lower than 10mm.

In a further aspect, the present invention relates to a method of fabrication of the module according to the present invention, comprising the step of forming the one-piece housing by deep drawing a single sheet of steel, and, preferably, subsequently galvanizing the housing.

Further characteristics and advantages will be more evident from the detailed description of some exemplary though not exclusive embodiments, among which also a preferred embodiment, of a module according to the present invention. This description will be disclosed below with reference to the accompanying drawings, provided to a merely indicative and therefore non-limiting purpose, in which:

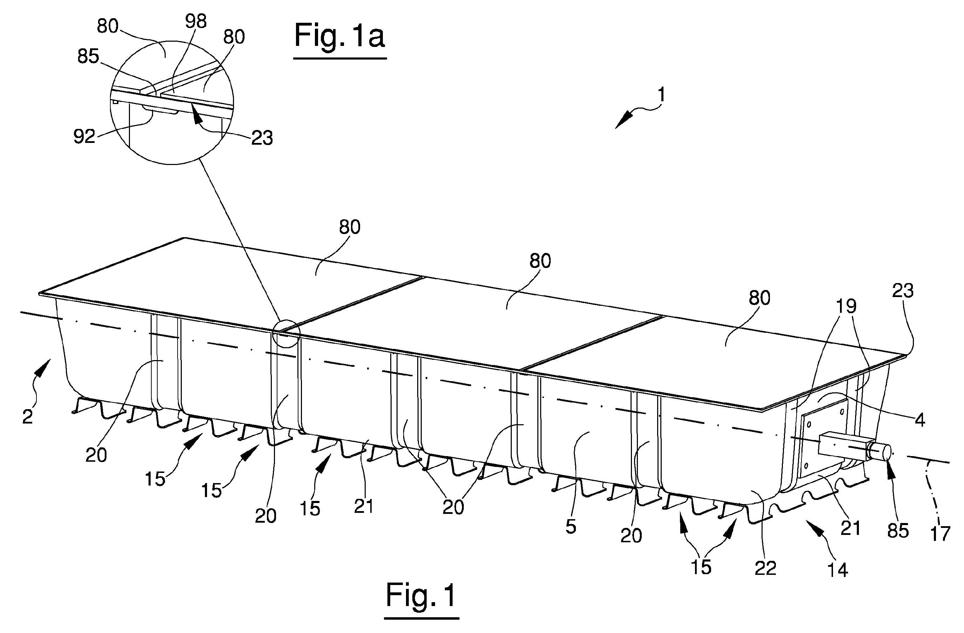

- Figure 1 is a schematic perspective view of a module for high concentrating photovoltaics according to the present invention;
- Figure 1 a is an enlarged view of a particular of figure 1;

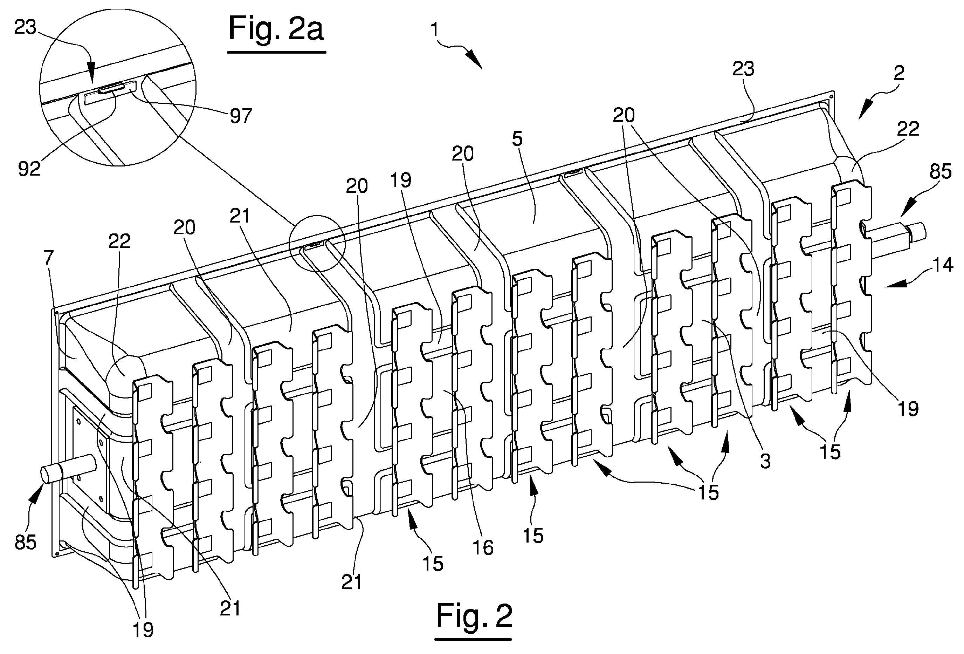

- Figure 2 is a further perspective view of the module of figure 1;
- Figure 2a is an enlarged view of a particular of figure 2;
- Figure 3 is a perspective view of the housing of the module of figure 1;
- Figure 3a is an enlarged view of a particular of figure 3;

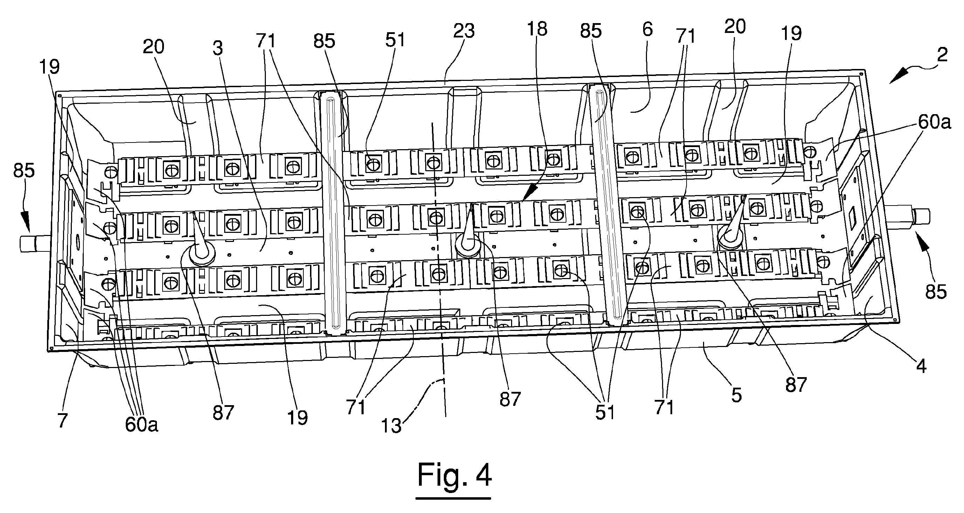

- Figure 4 is a perspective view of the module of figure 1 with some parts removed for better showing the inside of the housing;

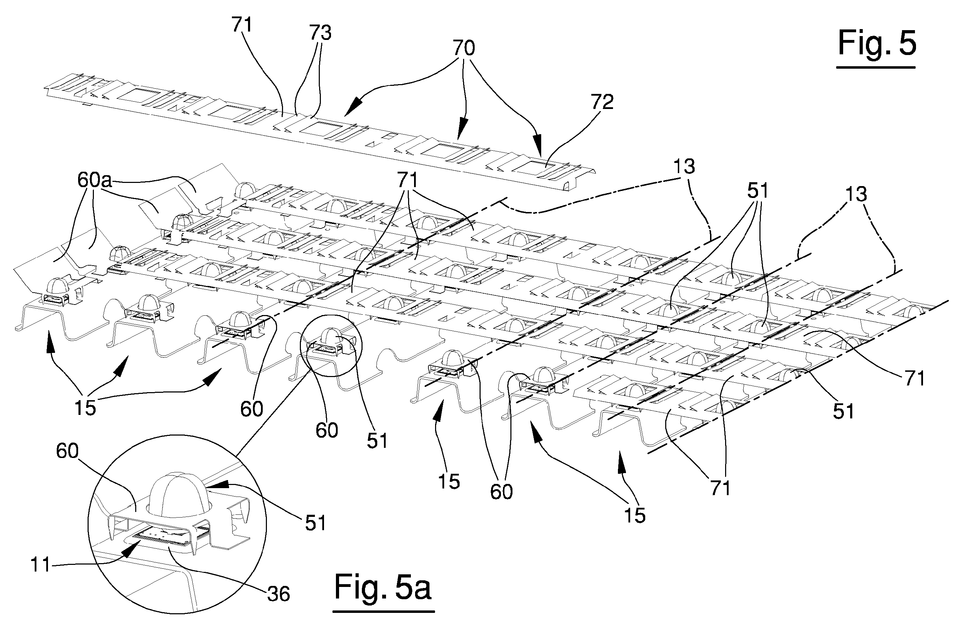

- Figure 5 is a partial perspective view, partially exploded, of the module of figure 1 with the housing and some further elements removed;
- Figure 5a is an enlarged view of a particular of figure 5;

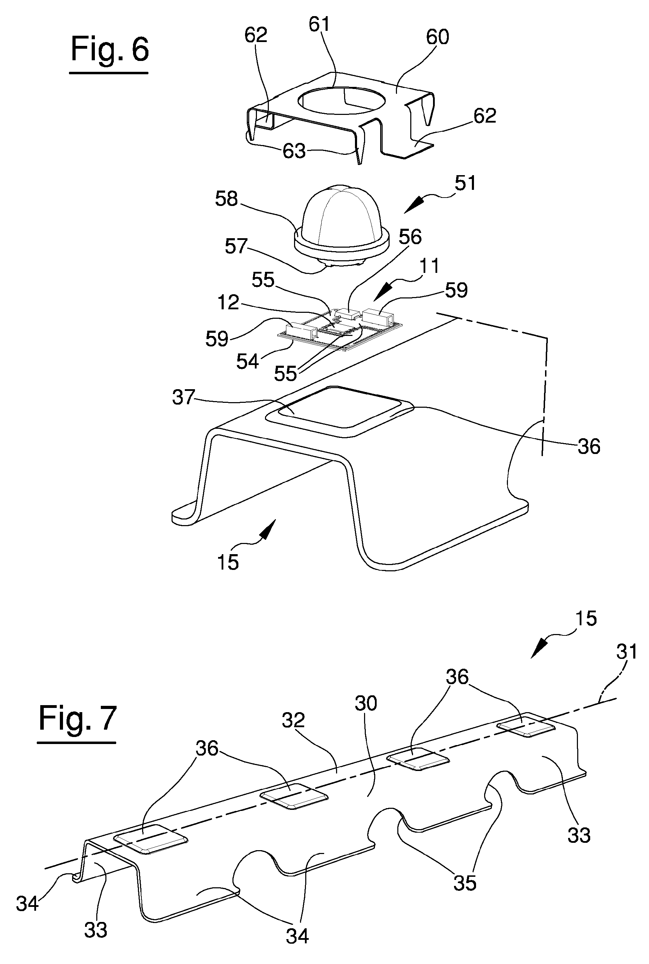

- Figure 6 is an enlarged and exploded view of a portion of figure 5;
- Figure 7 is a perspective view of the dissipating linear element of the module of figure 1;

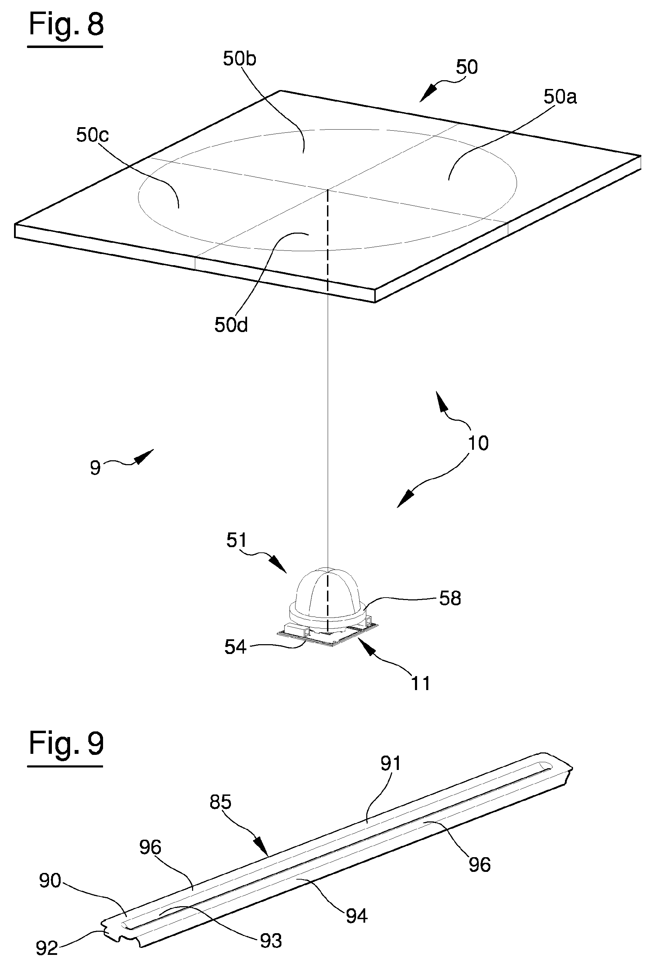

- Figure 8 is a schematic perspective view of a photovoltaic unit housed in the module of figure 1; and
- Figure 9 is a perspective view of a beam of the module of figure 4.

With reference to the attached figures, a module for high concentrating photovoltaics in accordance to the present invention is generally indicated with the reference number 1.

The module 1 includes a housing 2 having a bottom wall 3, four side walls 4, 5, 6, 7 (two longitudinal side walls 5, 6 and two transversal side walls 4, 7) connected to the bottom wall, and at least an aperture 8 located opposite the bottom wall.

Preferably, the housing is a one-piece housing. Preferably the housing is substantially made of steel (e.g. DC06 steel containing no more than about 0,12% of carbon.), formed by deep drawing a single sheet of steel having thickness of about 0.8mm. Preferably the housing is electrogalvanized and varnished on both sides.

Exemplarily, the housing dimensions along the longitudinal, transversal and depth directions are respectively about 155cm, 51cm and 20 cm and the thickness is equal to about 1.45mm (0.8mm of steel plus 0.08mm of galvanized zinc plus 0.25 mm of varnish for each side). It is noted that for a depth of the housing comprised between 15 cm and 25 cm as in a preferred embodiment of the present invention, stamping a comparative one-piece housing substantially made of aluminium would require a complex, inaccurate and costly stamping process (with typically several stamping steps).

Preferably, the housing integrally includes a first plurality (exemplarily two) of parallel and continuous ribs 19 running along the bottom wall (parallel to the longitudinal direction) and along the two transversal side walls (parallel to the depth direction) and a second plurality (exemplarily five) of parallel and continuous ribs 20 running along the bottom wall (parallel to the transversal direction) and along the two longitudinal side walls (parallel to the depth direction), the ribs of the second plurality crossing on the bottom wall perpendicularly to each rib of the first plurality. Preferably, each rib is formed as a protrusion with respect to the respective wall, the protrusion having exemplarily height of about 5mm and width of about 60mm. Preferably the protrusion develops towards the inner space of the housing.

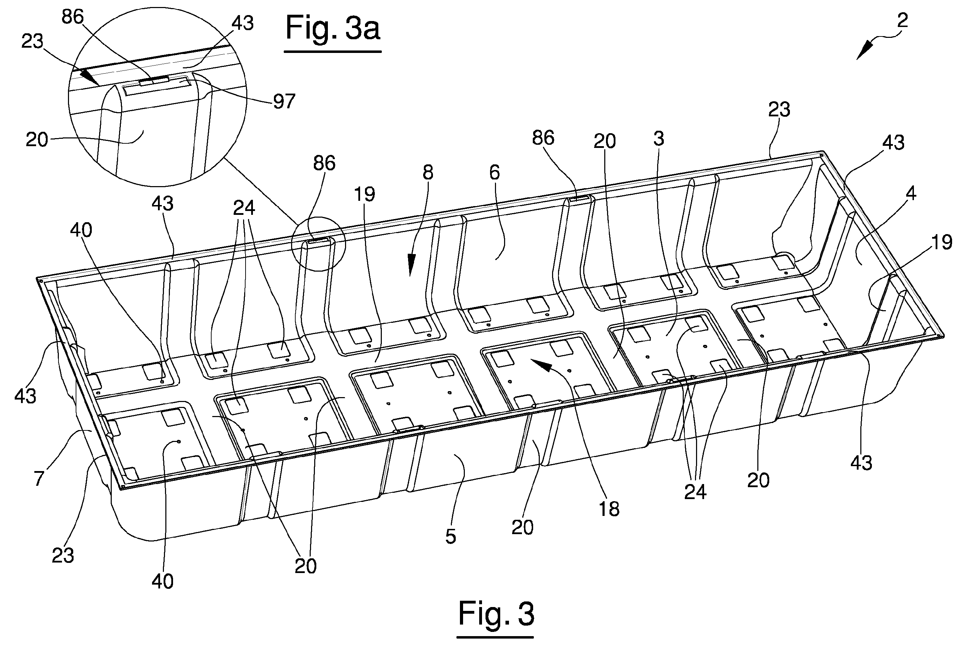

Preferably, the edges 21 formed between the bottom wall and the side walls, and the vertices 22 of the housing, are curved. Preferably, a portion 23 on the free edge of each side wall is outwardly bent with respect to the inner space of the housing, for a length of exemplarily 24mm. Preferably the bent portion defines a prop surface 43 (having exemplarily width of 10 mm) laying substantially perpendicularly to the respective side wall (or parallel to the bottom wall). Preferably, as exemplarily shown in Fig. 3a, the ribs 19 or 20 end on the portion 23, at the outset of the prop surface 43.

Preferably, the bottom wall has a plurality of through holes 24 regularly arranged along parallel rows. Preferably the holes are arranged along rows parallel to the transversal direction of the housing. More preferably, the holes are also arranged along rows parallel to the longitudinal direction of the housing, according to a matrix-type arrangement. Exemplarily, the rows are twelve, each one containing four holes, for a corresponding total number of 48 holes. Preferably, the holes have a rectangular shape, having exemplarily size 30x34,5mm.

The module comprises a plurality of photovoltaic units 9 housed in the housing (e.g. completely placed in the inner space 18, considering also the aperture), each one of said photovoltaic units comprising a concentrating optical system 10 having geometric concentrating factor greater than or equal to about 100 and a photovoltaic receiver 11 having a photovoltaic cell 12.

Preferably the photovoltaic receiver 11 comprises a dielectric thermally conductive substrate 54, pads 55 on a top layer of the substrate, the photovoltaic cell (PV) 12 with top and bottom electrodes bonded or soldered to the pads, and (typically) a bypass diode 56 in parallel to the cell 12 (that allows to short-circuit the cell in case of default). The receiver 11 typically comprises connectors 59 that allow to render available via a proper wiring the electrical power generated by the PV cell 12.

Preferably the photovoltaic cell 12 is a multi-junction cell preferably based on the III-V group element compound like InGaP, InGaAs and Ge on a Ge substrate, such as the commercially available photovoltaic receiver "Triple-Junction High Efficiency Heritage InGaP/InGaAs/Ge Solar Cell with n-on-p Polarity on Germanium Substrate" produced and marketed by Emcore Corporation. Preferably the physical size of the cell is 5,5x6,7 mm and the size of the active area of the cell is 5.5x5.5mm.

Typically, each concentrating optical system 10 comprises a primary optical element (POE) 50 for collecting the direct solar radiation from the outside of the housing and a secondary optical element (SOE) 51 for focusing the radiation collected from the POE onto the photovoltaic cell. Preferably the concentrating optical system is a refractive Fresnel-Köhler type optical system, wherein the POE comprises a planar, axially symmetric Fresnel lens (exemplarily having a total size of about 120x120 mm² and a focal length of about 20 cm), more preferably divided in four off-axis sectors 50a, 50b, 50c, 50d. The SOE 51 is a refractive lens also divided in four sectors. Advantageously, each off-axis sector of the POE refracts the light towards a corresponding sector of the SOE, which then directs the light onto the whole spot onto the solar cell, thus performing integration of the light and achieving outstanding irradiance uniformity on the solar cell. Preferably the SOE 51 is a three dimensional bulk lens made of an optical grade glass (e.g. borosilicate B270 or alike) with smooth surfaces compatible with conventional glass molding techniques. The top surface of the SOE has mainly an optical functionality and comprises four smooth peaks corresponding to the four sectors. Exemplarily, the geometric concentrating factor is equal to 576 as a result of an optical active area of the POE of 120x120mm² and a concentration of the solar radiation on top of the photovoltaic cell with a spot of 5x5 mm².

Preferably the bottom portion of the SOE 51 has a flat surface with four protruding pins 57 for leaning against the top surface of the photovoltaic receiver, typically against the pads thereof. The height of the pins is preferably designed so as to realize a distance between the flat surface on the bottom of the SOE and the top surface of the cell 12 in a range of about 0.20 - 0.30 mm (exemplarily 0.26 mm). An optical glue (not shown), preferably a transparent silicon based glue (such as Sylgard 184 by Dow Corning Inc.), is preferably applied on the flat surface on the bottom of the SOE in order to get an optical matching between the SOE and the PV cell and a permanent joint of the SOE with the receiver. According to the Applicant, the above range for the above distance allows on one side to avoid any mechanical loads on the wire/ribbon bonding and on the cell surface and, on the other side, the need of a very small quantity of optical glue, reducing the chances of getting air bubbles or other possible scattering sources.

Preferably, the external lateral surface of the SOE is provided with a protruding collar 58 developing perimetrically to the lateral surface (exemplarily the collar is a circular ring with stepped cross section). The module 1 preferably comprises a flange 60 for each SOE having a through hole 61 countershaped to the external perimeter of the lateral surface of the SOE and having internal dimension smaller than the outer dimension of the protruding collar 58. The flange 60 is preferably fixed to the (inner face of the) bottom wall, for example (not shown) by gluing, riveting or using adhesive tape, and leans against the top surface of the protruding collar, the upper portion of the SOE being inserted into the hole 61 of the flange. Advantageously, since, as noted by the Applicant, the lateral surface of the SOE has no optical functionality, it may be used (by means of the collar 61) to realize a (further) mechanical fastening of the SOE to the receiver substrate and of the SOE-receiver assembly to the bottom wall of the housing. This tightening solution may reduce the mechanical stress suffered by the glue placed between the SOE and the PV (with consequent possible detachment of the glue from the surface of the SOE or the PV) and/or may increase the robustness of the assembly to vibrations and/or to possible external mechanical stresses. Advantageously, the flange 60 also helps protecting the plastic parts of the components (diodes, wires, connectors, etc) from undesirable solar hot spots formed during possible module deviation from the perfect alignment with the solar direct normal incident beam. The flange 60, preferably of rectangular shape, has exemplarily tongues 62 for fastening to the bottom wall and three or four leaning pins 63 on the corners. The flange can be exemplarily realized from a bended conformed metal (e.g. steel) sheet (having exemplarily thickness between about 0.5 and 0.8 mm) with a suitable hole 61. It is noted that the flange 60a associated with the photovoltaic receivers closest to the transversal walls of the housing have a peculiar shape with a wing protruding toward the respective transversal wall in order to screen unwanted solar radiation (e.g. to protect underlying electrical wires). In a further embodiment (not shown), the flanges 60 have additional wings extending from opposite edges of the flange at an extent sufficient to protect from unwanted solar radiation the underlying components (e.g. electrical wires). Preferably, the latter winged flanges associated to a plurality of receivers along a line (e.g. a longitudinal line) are realized as a single-piece.

The module 1 preferably comprises a screen 70 associated to one or more photovoltaic receiver 11 configured for protecting the respective photovoltaic receiver, the bottom wall, and any other possible component of the module (such as wires, connectors, etc) from undesired solar radiation incident outside the desired focusing point(s) on the SOE. The screen, preferably fixed to the bottom wall, for example by gluing (not shown), typically comprises a through hole 72 (exemplarily having rectangular shape) and is positioned above the respective flange 60 of the respective receiver, the upper portion of the SOE being inserted into the hole of the screen. It is noted that the screens associated to the receivers closest to the transversal walls are not provided with the hole and extend only on one side of the respective photovoltaic receiver, since the wing of the flange 60a already screen unwanted solar radiation on the other side. Preferably, a one-piece screening element 71 realizes a plurality (exemplarily six) of the above screens 70 suitable for a line of receivers. Exemplarily, the screening elements 71 are oriented parallel to the longitudinal direction (exemplarily two for each longitudinal row of twelve receivers, for a total number of eight screening elements). The screening element 71 can be exemplarily realized from a bended conformed metal (e.g. steel) sheet, having exemplarily thickness between about 0.3 and 0.8 mm. Preferably, the screening elements 71 are provided with flaps 73 for enhancing the thermal convection inside the housing, the flaps being preferably structured so as to have a free edge distal from the SOE 51 and bended away from the screening element 71 toward the aperture 8 of the housing.

The module may further comprise a heat dissipating system 14 comprising a number of one-piece thermo conductive dissipating linear elements 15 for dissipating heat from the photovoltaic receivers. The dissipating linear elements are mounted onto an outer side 16 of the bottom wall.

The plurality of photovoltaic receivers 11 are preferably arranged at the bottom wall and regularly distributed according to a matrix scheme. Exemplarily, the receivers are arranged in twelve rows 13 parallel to the transversal direction of the housing, each one containing four receivers, for a total of forty-eight receivers.

Preferably, the number of dissipating linear elements 15 (exemplarily twelve) is equal to the number of the above rows 13. The photovoltaic receivers arranged along each of the row 13 are mounted onto a corresponding one dissipating linear element so as to realize a thermal bridge between each photovoltaic receiver and the corresponding dissipating linear element.

Preferably, the holes 24 are positioned in correspondence to the position of the photovoltaic receivers. Preferably, the photovoltaic receivers arranged along each of the above row 13 are directly mounted (preferably by way of a thermal conductive glue -not shown- that is able to guarantee a good heat exchange coefficient) onto the corresponding one of the dissipating linear elements 15.

Preferably, as in the example shown in the drawings, the dissipating elements (and the rows 13) are aligned along the transversal direction of the housing. In an alternative embodiment (not shown), the dissipating elements are aligned along the longitudinal direction of the housing.

Exemplarily, the dissipating linear elements are made from a material including about 95% of aluminum and at least 2.6% of magnesium.

Preferably, the dissipating linear element 15 is a plate-like element 30 having a main longitudinal (with respect to the dissipating element itself) extension 31, a central longitudinal portion 32 lying substantially on a lying plane and, extending from the opposite longitudinal edges of the central portion, a pair of opposite flaps 33 extending in the same half-space with respect to the lying plane and substantially orthogonally to the lying plane. Preferably the flaps are mirror flaps with respect to a symmetry plane perpendicular to the lying plane and centrally intersecting the central longitudinal portion parallel to the main longitudinal extension of the dissipating linear element. Preferably, an end portion 34 on the free edge of each flap is outwardly bent with respect to the symmetry plane, for a length comprised between about 5mm and 50 mm, exemplarily 10mm. This bent end portion may advantageously reduce the total encumbrance of the module 1 along the depth direction (which may have implications on the problem of shadowing on/by neighbouring modules), while maintaining satisfactory the overall thermal dissipation efficiency of the element 15. Preferably the bent portion 34 is curved. Preferably, cut-outs 35 are realized on the free edge of each flap and extending about up to half of the height of the flap. The cut-outs are positioned midway the positions of two adjacent photovoltaic receivers. Preferably the cut-outs are approximately circular in shape.

Preferably, each dissipating linear element integrally comprises a number, equal to the number of photovoltaic receivers mounted onto the dissipating linear element, of mounting portions 36 protruding from the upper face of the central longitudinal portion 32. Each mounting portion has a flat top surface 37 and a shape countershaped to the shape of the hole 24 of the bottom wall of the housing (preferably a rectangular shape), so as to be inserted in the latter. Preferably, a sealing (not shown) such as a silicon-based sealing is used on the perimeter of the mounting portion 36 to seal the interstices between the bottom wall of the housing, around the hole, and the dissipating linear element.

Each photovoltaic receiver 11 is (preferably directly) mounted on a respective mounting portion 36. Preferably, the height of the mounting portions 36 with respect to the upper face of the remaining central longitudinal portion from which they protrude is greater than the thickness of the bottom wall of the housing. Preferably, the dissipating linear element is realized by a stamping process comprising deep drawing an aluminum planar sheet of suitable shape. Exemplarily, the thickness of the dissipating linear element is equal to 2.0mm.

Preferably, the dissipating linear elements are mounted onto the bottom wall by rivets, the position of which is exemplarily shown by the reference numbers 40 in figure 3. Preferably, the number of rivets for each dissipating element is equal to three and, more preferably, they are unaligned. It is noted that the stiffness of the aluminum dissipating linear elements may be higher than the one of the housing bottom wall due to the shape and the different thickness. Under these circumstances, the ribs 19 running along the bottom wall perpendicularly to the dissipating linear elements may act as a spring absorbing the stress generated on the bottom wall of the housing due to thermal expansions.

Preferably, the module 1 comprises a plurality (e.g. three) of parquets 80 (shown only schematically) comprising an array (preferably 4x4 each) of POE lenses manufactured together as one piece. Typically the parquet(s) is/are positioned on the aperture 8 of the housing so as to cover it. Exemplarily each parquet consists of a rigid polymethilmetaacrilate (PMMA) plastic substrate of about 3mm thickness with a separate thin polymer film laminated on it and realizing (e.g. by means of micro-embossing) a Fresnel profile defining the POEs.

Preferably, the module comprises two beams 85 each one spanning transversally the aperture 8 of the housing and having their opposite longitudinal (with respect to the beam itself) ends fixed respectively to the free edge of the longitudinal side walls. Preferably, the beams are positioned so as to divide the aperture 8 in three equal parts.

Preferably, each beam is a plate-like element 90 having a main longitudinal extension, a main longitudinal portion 91 lying substantially on a lying plane and, extending from the opposite transversal edges of the main longitudinal portion, a pair of opposite tongues 92 extending away from the lying plane of the beam in the same half-space with respect to the lying plane and obliquely to the lying plane, preferably substantially orthogonally to the lying plane. Preferably, the width of the tongues 92 is smaller than the transversal width of the beam. Preferably, the main longitudinal portion integrally includes a continuous rib 93 running longitudinally the main longitudinal portion (preferably midway the main longitudinal portion). The rib 93 preferably protrudes toward the inner space of the housing. Preferably, extending from the opposite longitudinal edges of the main longitudinal portion, a pair of opposite flaps 94 extend away from the lying plane of the beam toward the inner space of the housing and obliquely to the lying plane, preferably substantially orthogonally to the lying plane. According to the Applicant, the rib 93 and/or the flaps 94 may increase the stiffness of the beam with respect to longitudinal flexion and/or torsion, thus increasing the stiffness of the module along the transversal direction and/or keeping constant the distance between the POE and the SOE. Preferably, the main longitudinal portion 91 has a respective prop surface 96, preferably extending all around the rib 93.

Preferably, the free edge of each longitudinal wall 5, 6 shows a through slot 86 for each beam 85, preferably placed on the bent portion 23 thereof. More preferably, two slots 86 are placed respectively on the opposite ends of a rib 20. Preferably the tongues 92 of each beam are snapped into a corresponding pair of slots 86.

Preferably two opposite edges of the central parquet and three edges of the two end parquets lean against the prop surface 43 of the bent portion 23 of the side walls. Preferably two opposite edges of the central parquet and one edge of the two end parquets lean against the prop surface 96 of the main longitudinal portion 91 of a beam. Preferably, each end of a respective rib 20 associated to a beam 85 is provided with a notch 97 protruding outwardly the housing, so as to allow that the prop surface 96 of the beam is level with the prop surface 43 of the housing.

Preferably, the parquet 80 is provided with a perimetral edge 98 of exemplarily about 15 mm width beyond the optical effective area of the parquet. This solution may help attaching the parquet to the side walls and/or to the beam(s). The dimensions of the aperture 8 up to the prop surface 43 are designed so that a gap of about 4 mm is formed all around the perimetral edge of each parquet. This may allow the parquet thermal and/or hygroscopic expansions. In fact, in case of PMMA parquet, having thermal expansion coefficient of 7,0x10⁻⁵ °C⁻¹, this may thermally expands about six times more than the steel housing.

Preferably, suitable material (not shown) (for example a combination of a bi-adhesive tape such as the 9515 tape by 3M Corporation and a silicon sealing such the 744 sealant by Dow Corning Corporation) is placed between the prop surface 43 of the side walls and/or the prop surface 96 of the beam(s) and the perimetral edge 98 of the parquet, the material having suitable stick properties to guarantee the joining,a suitable elasticity for the purpose of the absorption of the above expansions and a suitable sealing property.

Preferably the module 1 includes one pillar 87 for each parquet 80 having a base fixed to the bottom wall and a tip opposite to the base fixed to the geometrical center of the respective parquet so as to keep spatially fixed the center of the parquet both in the depth direction of the housing and in any orthogonal direction thereof.

To avoid the entry of water, insects and/or dust, the housing is preferably sealed on all the interstices of the module bridging to the outside. A valve (not shown) is preferably mounted to the housing suitable to compensate possible different pressure conditions inside and outside the module. This reduces the arising of stresses due to unbalanced pressure, which could deform in particular the POE parquet or even break it. This valve may be a commercially available valve and allows the air flux through the valve but at the same time is a filter that avoids the passage of humidity through it. The dimensions of the valve should guarantee a minimum flux of air to react to quick changes of temperature (e.g. due to a summer storm).

Preferably, the module comprises a pair of mounting bodies 85, preferably stably fixed to the transversal walls 4 and 7 respectively, and configured for mounting the module 1 to a tracker and to allow a rotation around the longitudinal direction.

The Applicant has performed experimental tests on the module 1 according to the preferred embodiment as described above and depicted in the drawings, in order to assess, among others, the thermal behaviour. The measured temperature at the external surface of the dissipating linear element in correspondence to the cell was less than about 70°C, for a corresponding cell efficiency of about 27%, with a solar radiation equal to about 900 W/m² and an air temperature of 35°C (with summer breeze), and less than about 60°C, for a corresponding cell efficiency of about 29%, with a solar radiation equal to about 800 W/m² and an air temperature of 28°C.

## Claims

1. A module (1) for high concentrating photovoltaics including a housing (2) having a bottom wall (3), one or more side walls (4, 5, 6, 7) connected to the bottom wall, and at least an aperture (8) located opposite the bottom wall, and a plurality of photovoltaic units (9) housed in the housing, each one of said photovoltaic units comprising a concentrating optical system (10) having a geometric concentrating factor greater than or equal to about 100 and a photovoltaic receiver (11) having a photovoltaic cell (12), wherein the plurality of photovoltaic receivers are arranged along a plurality of parallel rows (13), the module further comprising a heat dissipating system (14) comprising a number of dissipating linear elements (15) for dissipating heat from the photovoltaic receivers, the dissipating linear elements being mounted onto an outer side (16) of the bottom wall, wherein the bottom wall has a plurality of through holes (24) corresponding in number and position to respectively the number and position of the photovoltaic receivers and wherein the photovoltaic receivers arranged along each of said rows are mounted onto a corresponding one of said dissipating linear elements so as to realize a thermal bridge between each photovoltaic receiver and the corresponding dissipating linear element.

2. The module of claim 1, wherein the dissipating linear elements are made from a material including at least 90% of aluminum.

3. The module of claim 1 or 2, wherein the housing is formed by a sheet of steel having maximum thickness greater than or equal to 0.65mm and less than or equal to 1.1 mm.

4. The module of any one of claims 1 to 3, wherein the housing integrally includes a first plurality of parallel and continuous ribs (19) running along the bottom wall and the two transversal side walls and a second plurality of parallel and continuous ribs (20) running along the bottom wall and the two longitudinal side walls, the ribs of the second plurality crossing on the bottom wall perpendicularly to each rib of the first plurality, each rib being formed as a protrusion with respect to the respective wall, the protrusion developing towards the inner space of the housing.

5. The module of any one of claims 1 to 4, wherein the edges (21) formed between the bottom wall and the side walls, and the vertices (22) of the housing, are rounded and a portion (23) on the free edge of each side wall is outwardly bent with respect to the inner space of the housing, the bent portion defining a prop surface (43) laying substantially perpendicularly to the respective side wall.

6. The module of any one of claims 1 to 5, wherein the dissipating linear elements are aligned along the transversal direction of the housing.

7. The module of any one of claims 1 to 6, wherein the dissipating linear element is a plate-like element (30) having a main longitudinal extension (31) and a central longitudinal portion (32) lying substantially on a lying plane and having two mutually opposite edges developing longitudinally to the dissipating element, and wherein from said opposite edges of the central longitudinal portion a pair of opposite flaps (33) extend in the same half-space with respect to the lying plane and obliquely to the lying plane, the flaps being mirror flaps with respect to a symmetry plane perpendicular to the lying plane and centrally intersecting the central longitudinal portion parallel to the main longitudinal extension of the dissipating linear element.

8. The module of claim 7, wherein cut-outs (35) are realized on the free edge of each flap and extending up to about half of the height of the flap, the cut-outs being positioned midway the positions of two adjacent photovoltaic receivers.

9. The module of any one of claims 1 to 8, wherein the photovoltaic receivers arranged along each of said row are directly mounted onto the corresponding one of said dissipating linear elements.

10. The module of claim 9, when depending on claim 7 or 8, wherein each dissipating linear element integrally comprises a number, equal to the number of photovoltaic receivers mounted onto the dissipating linear element, of mounting portions (36) protruding from the upper face of the central longitudinal portion (32) of the dissipating linear element, each mounting portion having a flat top surface (37) and a shape countershaped to the shape of said hole (24) of the bottom wall of the housing, and being inserted in the latter, and wherein each photovoltaic receiver (11) is directly mounted on a respective mounting portion of the dissipating linear element.

11. The module of claim 10, wherein the height of the mounting portions (36) with respect to the upper face of the central longitudinal portion from which they protrude is greater than the thickness of the bottom wall.

12. The module of any one of claims 1 to 11, wherein the thickness of the dissipating linear element (15) is greater than or equal to 1.5mm and less than or equal to 2.5mm.

13. The module of any one of claims 1 to 12, wherein the dissipating linear elements (15) are mounted onto the bottom wall by riveting, the number of rivets for each dissipating linear element being less than the number of the photovoltaic receivers mounted onto the respective dissipating linear element.

14. The module of any one of claims 1 to 13, wherein each concentrating optical system (10) comprises a primary optical element (50) for collecting the direct solar radiation from the outside of the housing and a secondary optical element (51) for focusing the radiation collected from the primary optical element onto the photovoltaic cell and wherein the module comprises at least one parquet (80) comprising an array of adjacent primary optical elements manufactured together as one piece, the parquet being positioned on the aperture (8) of the housing so as to cover it.

15. The module of claim 14, wherein the module comprises at least one beam (85) spanning transversally the aperture (8) of the housing and having its opposite longitudinal ends fixed respectively to the free edge of the longitudinal side walls, at least one edge of said parquet leaning against said beam.

16. The module of claim 14 or 15, wherein the module includes one pillar (87) for each parquet having a base fixed to the bottom wall and a tip opposite to the base fixed to the geometrical center of the respective parquet so as to keep spatially fixed the center of the parquet both in the depth direction of the housing and in any orthogonal direction thereof.

17. The module of any one of claims 14 to 16, wherein the secondary optical element (51) is a three dimensional bulk lens having an external lateral surface provided with a protruding collar (58) developing perimetrically to the external lateral surface, the module further comprising a flange (60) for each secondary optical element having a through hole (61) countershaped to the perimeter of the external lateral surface of the secondary optical element and having internal dimension smaller than the outer dimension of the protruding collar (58), the flange being fixed to an inner face of the bottom wall and leaning against a top surface of the protruding collar, an upper portion of the secondary optical element being inserted into the hole (61) of the flange (60).

18. A method of fabrication of the module according to any one of claims 1 to 17, wherein the housing is a one-piece housing having depth greater than or equal to 15 cm, the method comprising the step of forming the one-piece housing by deep drawing a single sheet of steel, and, preferably, subsequently zinc-coating the housing.

## Patentansprüche

1. Modul (1) für die Hochkonzentrator-Photovoltaik, mit einem Gehäuse (2) mit einer unteren Wand (3), einer oder mehreren Seitenwänden (4, 5, 6, 7), die mit der unteren Wand verbunden sind, und zumindest einer Öffnung (8), die gegenüber der unteren Wand angeordnet ist, sowie einer Vielzahl von Photovoltaikeinheiten (9), die in dem Gehäuse untergebracht sind, wobei jede der Photovoltaikeinheiten ein optisches Konzentratorsystem (10) umfasst, mit einem geometrischen Konzentrationsfaktor größer oder gleich etwa 100 und einem Photovoltaikempfänger (11) mit einer Photovoltaikzelle (12), wobei die Vielzahl von Photovoltaikempfängern entlang einer Vielzahl von parallelen Reihen (13) angeordnet ist, wobei das Modul des Weiteren ein Wärmeableitsystem (14) mit einer Anzahl von linearen Ableitelementen (15) zur Ableitung von Wärme von den Photovoltaikempfängern umfasst, wobei die linearen Ableitelemente an einer Außenseite (16) der unteren Wand montiert sind, wobei die untere Wand eine Vielzahl von Durchgangslöchern (24) aufweist, die in Anzahl und Position jeweils der Anzahl und Stellung der Photovoltaikempfänger entsprechen, und wobei die Photovoltaikempfänger, die entlang jeder der Reihen angeordnet sind, so an einem entsprechenden der linearen Ableitelemente montiert sind, dass eine Wärmebrücke zwischen jedem Photovoltaikempfänger und dem entsprechenden linearen Ableitelement realisiert wird.

2. Modul nach Anspruch 1, wobei die linearen Ableitelemente aus einem Material hergestellt sind, das zumindest 90 % Aluminium umfasst.

3. Modul nach Anspruch 1 oder 2, wobei das Gehäuse aus einem Stahlblech mit einer maximalen Dicke größer als oder gleich 0,65 mm und kleiner als oder gleich 1,1 mm gebildet ist.

4. Modul nach einem der Ansprüche 1 bis 3, wobei das Gehäuse einteilig eine erste Vielzahl von parallelen und durchgängigen Rippen (19) umfasst, die entlang der unteren Wand und der zwei Querseitenwände verlaufen, sowie eine zweite Vielzahl von parallelen und durchgängigen Rippen (20), die entlang der unteren Wand und der zwei Längsseitenwände verlaufen, wobei die Rippen der zweiten Vielzahl an der unteren Wand jede Rippe der ersten Vielzahl senkrecht kreuzen, wobei jede Rippe als ein Vorsprung in Bezug auf die jeweilige Wand gebildet ist, wobei sich der Vorsprung in Richtung des Gehäuseinneren fortsetzt.

5. Modul nach einem der Ansprüche 1 bis 4, wobei die Ränder (21), die zwischen der unteren Wand und den Seitenwänden gebildet sind, sowie die Eckpunkte (22) des Gehäuses abgerundet sind, und ein Abschnitt (23) an dem freien Rand jeder Seitenwand in Bezug auf das Gehäuseinnere nach außen gebogen ist, wobei der gebogene Abschnitt eine Stützfläche (43) definiert, die im Wesentlichen senkrecht zu der jeweiligen Seitenwand liegt.

6. Modul nach einem der Ansprüche 1 bis 5, wobei die linearen Ableitelemente entlang der Querrichtung des Gehäuses ausgerichtet sind.

7. Modul nach einem der Ansprüche 1 bis 6, wobei das lineare Ableitelement ein plattenartiges Element (30) mit einer Hauptlängserstreckung (31) und einem zentralen Längsabschnitt (32) ist, der im Wesentlichen auf einer liegenden Ebene liegt und zwei einander gegenüberliegende Ränder aufweist, die sich in Längsrichtung zu dem Ableitelement fortsetzen, und wobei sich von den gegenüberliegenden Rändern des zentralen Längsabschnitts ein Paar von gegenüberliegenden Laschen (33) im selben Halbraum in Bezug auf die liegende Ebene und schräg zu der liegenden Ebene erstrecken, wobei die Laschen spiegelbildliche Laschen in Bezug auf eine Symmetrieebene sind, die senkrecht auf die liegende Ebene seht und den zentralen länglichen Abschnitt parallel zu der Hauptlängserstreckung des linearen Ableitelements zentral überkreuzt.

8. Modul nach Anspruch 7, wobei Ausschnitte (35) an dem freien Rand jeder Lasche ausgeführt sind und sich bis etwa zur Hälfte der Höhe der Lasche erstrecken, wobei die Ausschnitte mittig zwischen den Positionen zweier benachbarter Photovoltaikempfänger positioniert sind.

9. Modul nach einem der Ansprüche 1 bis 8, wobei die Photovoltaikempfänger, die entlang jeder der Reihen angeordnet sind, direkt auf dem entsprechenden der linearen Ableitelemente montiert sind.

10. Modul nach Anspruch 9, sofern abhängig von Anspruch 7 oder 8, wobei jedes lineare Ableitelement einteilig eine der Anzahl von auf dem linearen Ableitelement montierten Photovoltaikempfängern gleichkommende Anzahl von Montageabschnitten (36) umfasst, die von der oberen Fläche des zentralen Längsabschnitts (32) des linearen Ableitelements wegragen, wobei jeder Befestigungsabschnitt eine flache obere Oberfläche (37) und eine dem Loch (24) der unteren Wand des Gehäuses gegengleich geformte Gestalt aufweist und in letzteres eingesetzt ist, und wobei jeder Photovoltaikempfänger (11) direkt an einem jeweiligen Befestigungsabschnitt des linearen Ableitelements montiert ist.

11. Modul nach Anspruch 10, wobei die Höhe der Befestigungsabschnitte (36) in Bezug auf die obere Fläche des zentralen Längsabschnitts, von der sie wegragen, größer als die Dicke der unteren Wand ist.

12. Modul nach einem der Ansprüche 1 bis 11, wobei die Dicke des linearen Ableitelements (15) größer oder gleich 1,5 mm und kleiner oder gleich 2,5 mm ist.

13. Modul nach einem der Ansprüche 1 bis 12, wobei die linearen Ableitelemente (15) an der unteren Wand durch Nieten montiert sind, wobei die Anzahl der Nieten für jedes lineare Ableitelement geringer ist als die Anzahl der Photovoltaikempfänger, die an dem jeweiligen linearen Ableitelement montiert sind.

14. Modul nach einem der Ansprüche 1 bis 13, wobei jedes optische Konzentratorsystem (10) ein primäres optisches Element (50) zum Sammeln der direkten Sonnenstrahlung von außerhalb des Gehäuses sowie ein sekundäres optisches Element (51) zum Fokussieren der von dem primären optischen Element gesammelten Strahlung auf der Photovoltaikzelle zu fokussieren, und wobei das Modul zumindest eine Täfelung (80) umfasst, die eine Feldanordnung benachbarter primärer optischer Elemente umfasst, die zusammen als ein Stück hergestellt sind, wobei die Täfelung an der Öffnung (8) des Gehäuses positioniert ist, um dieses abzudecken.

15. Modul nach Anspruch 14, wobei das Modul zumindest einen Träger (85) umfasst, der die Öffnung (8) des Gehäuses quer überspannt und seine gegenüberliegenden Längsenden jeweils an dem freien Rand der Längsseitenwände fixiert hat, wobei zumindest ein Rand der Täfelung gegen den Träger anliegt.

16. Modul nach Anspruch 14 oder 15, wobei das Modul eine Säule (87) für jede Täfelung umfasst, mit einer an der unteren Wand fixierten Basis und einer der Basis gegenüberliegenden Spitze, die am geometrischen Mittelpunkt der jeweiligen Täfelung fixiert ist, um den Mittelpunkt der Täfelung räumlich sowohl in der Tiefenrichtung des Gehäuses als auch in jeder orthogonalen Richtung dazu fixiert zu halten.

17. Modul nach einem der Ansprüche 14 bis 16, wobei das sekundäre optische Element (51) eine dreidimensionale große Linse mit einer äußeren Seitenfläche, die mit einem vorspringenden Kragen (58) versehen ist, der sich umlaufend zu der äußeren Seitenfläche erstreckt, umfasst, wobei das Modul des Weiteren einen Flansch (60) für jedes sekundäre optische Element aufweist, der ein Durchgangsloch (61) umfasst, das gegengleich zu dem Umfang der äußeren Seitenfläche des sekundären optischen Elements gebildet ist und eine innere Abmessung aufweist, die kleiner ist als die äußere Dimension des vorspringenden Kragens (58), wobei der Flansch an einer inneren Seitenfläche der unteren Wand fixiert ist und gegen eine obere Oberfläche des vorspringenden Kragens anliegt, wobei ein oberer Abschnitt des sekundären optischen Elements in das Loch (61) des Flansches (60) eingesetzt ist.

18. Verfahren zur Fertigung des Moduls nach einem der Ansprüche 1 bis 17, wobei das Gehäuse ein einstückiges Gehäuse mit einer Tiefe größer oder gleich 15 cm ist, wobei das Verfahren den Schritt des Bildens des einstückigen Gehäuses durch Tiefziehen eines einzelnen Stahlblechs und vorzugsweise darauffolgendes Beschichten des Gehäuses mit Zink umfasst.

## Revendications

1. Module (1) pour un photovoltaïque à concentration élevée comportant un boîtier (2) ayant une paroi inférieure (3), une ou plusieurs paroi (s) latérale(s) (4, 5, 6, 7) reliée(s) à la paroi inférieure, et au moins une ouverture (8) située à l'opposé de la paroi inférieure, et une pluralité d'unités photovoltaïques (9) reçues dans le boîtier, chacune desdites unités photovoltaïques comprenant un système optique de concentration (10) ayant un facteur de concentration géométrique supérieur ou égal à environ 100, et un récepteur photovoltaïque (11) ayant une cellule photovoltaïque (12), où la pluralité de récepteurs photovoltaïques sont agencés le long d'une pluralité de rangées parallèles (13), le module comprenant en outre un système de dissipation de chaleur (14) comprenant un nombre d'éléments linéaires de dissipation (15) pour dissiper de la chaleur des récepteurs photovoltaïques, les éléments linéaires de dissipation étant montés sur un côté externe (16) de la paroi inférieure, où la paroi inférieure a une pluralité de trous traversants (24) correspondant en nombre et en position respectivement au nombre et à la position des récepteurs photovoltaïques et où les récepteurs photovoltaïques agencés le long de chacune desdites rangées sont montés sur un élément correspondant desdits éléments linéaires de dissipation de manière à réaliser un pont thermique entre chaque récepteur photovoltaïque et l'élément linéaire de dissipation correspondant.

2. Module de la revendication 1, dans lequel les éléments linéaires de dissipation sont réalisés en un matériau comportant au moins 90% d'aluminium.

3. Module de la revendication 1 ou 2, dans lequel le boîtier est formé par une feuille d'acier ayant une épaisseur maximale supérieure ou égale à 0,65 mm et inférieure ou égale à 1,1 mm.

4. Module de l'une quelconque des revendications 1 à 3, dans lequel le boîtier comporte d'un seul tenant une première pluralité de nervures (19) parallèles et continues s'étendant le long de la paroi inférieure et des deux parois latérales transversales et une deuxième pluralité de nervures (20) parallèles et continues s'étendant le long de la paroi inférieure et deux parois latérales longitudinales, les nervures de la deuxième pluralité traversant la paroi inférieure perpendiculairement à chaque nervure de la première pluralité, chaque nervure étant formée en tant que saillie par rapport à la paroi respective, la saillie se développant vers l'espace interne du boîtier.

5. Module de l'une quelconque des revendications 1 à 4, dans lequel les bords (21) formés entre la paroi inférieure et les parois latérales, et les sommets (22) du boîtier, sont arrondis et une partie (23) sur le bord libre de chaque paroi latérale est pliée vers l'extérieur par rapport à l'espace interne du boîtier, la partie pliée définissant une surface de soutien (43) se trouvant de manière essentiellement perpendiculaire à la paroi latérale respective.

6. Module de l'une quelconque des revendications 1 à 5, dans lequel les éléments linéaires de dissipation sont alignés le long de la direction transversale du boîtier.

7. Module de l'une quelconque des revendications 1 à 6, dans lequel l'élément linéaire de dissipation est un élément en forme de plaque (30) ayant une extension longitudinale principale (31) et une partie centrale longitudinale (32) se trouvant essentiellement sur un plan de pose et ayant deux bords mutuellement opposés se développant longitudinalement à l'élément de dissipation, et où à partir desdits bords opposés de la partie centrale longitudinale, une paire de rabats opposés (33) s'étendent dans le même demi-espace par rapport au plan de pose et de manière oblique par rapport au plan de pose, les rabats étant des rabats miroirs par rapport à un plan de symétrie perpendiculaire au plan de pose et coupant au centre la partie centrale longitudinale parallèle à l'extension longitudinale principale de l'élément linéaire de dissipation.

8. Module de la revendication 7, dans lequel des découpes (35) sont réalisées sur le bord libre de chaque rabat et s'étendant jusqu'à environ la moitié de la hauteur du rabat, les découpes étant positionnées à mi-chemin des positions de deux récepteurs photovoltaïques adjacents.

9. Module de l'une quelconque des revendications 1 à 8, dans lequel les récepteurs photovoltaïques agencés le long de chacune desdites rangées sont directement montés sur l'élément correspondant desdits éléments linéaires de dissipation.

10. Module de la revendication 9, lorsqu'elle dépend de la revendication 7 ou 8, dans lequel chaque élément linéaire de dissipation comprend d'un seul tenant un nombre égal au nombre de récepteurs photovoltaïques montés sur l'élément linéaire de dissipation, de parties de montage (36) faisant saillie à partir de la face supérieure de la partie centrale longitudinale (32) de l'élément linéaire de dissipation, chaque partie de montage ayant une surface supérieure plane (37) et une forme complémentaire à la forme dudit trou (24) de la paroi inférieure du boîtier, et étant insérée dans cette dernière, et où chaque récepteur photovoltaïque (11) est directement monté sur une partie de montage respective de l'élément linéaire de dissipation.

11. Module de la revendication 10, dans lequel la hauteur des parties de montage (36) par rapport à la face supérieure de la partie centrale longitudinale à partir de laquelle elles font saillie est supérieure à l'épaisseur de la paroi inférieure.

12. Module de l'une quelconque des revendications 1 à 11, dans lequel l'épaisseur de l'élément linéaire de dissipation (15) est supérieure ou égale à 1,5 mm et inférieure ou égale à 2,5 mm.

13. Module de l'une quelconque des revendications 1 à 12, dans lequel les éléments linéaires de dissipation (15) sont montés sur la paroi inférieure par rivetage, le nombre de rivets pour chaque élément linéaire de dissipation étant inférieur au nombre des récepteurs photovoltaïques montés sur l'élément linéaire de dissipation respectif.

14. Module de l'une quelconque des revendications 1 à 13, dans lequel chaque système optique de concentration (10) comprend un élément optique primaire (50) pour collecter le rayonnement solaire direct depuis l'extérieur du boîtier et un élément optique secondaire (51) pour focaliser le rayonnement collecté par l'élément optique primaire sur la cellule photovoltaïque, et où le module comprend au moins un parquet (80) comprenant un réseau d'éléments optiques primaires adjacents fabriqués ensemble en une seule pièce, le parquet étant positionné sur l'ouverture (8) du boîtier de manière à la couvrir.

15. Module de la revendication 14, dans lequel le module comprend au moins une poutre (85) enjambant transversalement l'ouverture (8) du boîtier et ayant ses extrémités longitudinales opposées fixées respectivement au bord libre des parois latérales longitudinales, au moins une bord dudit parquet s'appuyant contre ladite poutre.

16. Module de la revendication 14 ou 15, dans lequel le module comporte un pilier (87) pour chaque parquet ayant une base fixée à la paroi inférieure et une pointe opposée à la base fixée au centre géométrique du parquet respectif de manière à maintenir le centre du parquet fixe dans l'espace à la fois dans la direction de la profondeur du boîtier et dans une direction orthogonale quelconque de celui-ci.

17. Module de l'une quelconque des revendications 14 à 16, dans lequel l'élément optique secondaire (51) est une lentille en masse tridimensionnelle ayant une surface latérale externe munie d'un collier en saillie (58) se développant sur le périmètre de la surface latérale externe, le module comprenant en outre une bride (60) pour chaque élément optique secondaire ayant un trou traversant (61) de forme complémentaire au périmètre de la surface latérale externe de l'élément optique secondaire et ayant une dimension interne inférieure à la dimension externe du collier en saillie (58), la bride étant fixée à une face interne de la paroi inférieure et s'appuyant contre une surface supérieure du collier en saillie, une partie supérieure de l'élément optique secondaire étant insérée dans le trou (61) de la bride (60).

18. Procédé de fabrication du module de l'une quelconque des revendications 1 à 17, dans lequel le boîtier est un boîtier monobloc ayant une profondeur supérieure ou égale à 15 cm, le procédé comprenant l'étape qui consiste à former le boîtier monobloc par emboutissage profond d'une seule feuille d'acier, et de préférence, par zingage ultérieur du boîtier.
